# EUROPÄISCHE PATENTSCHRIFT

(11) **EP 3 639 334 B1**
(45) Veröffentlichungstag und Bekanntmachung des Hinweises auf die Patenterteilung: **27.10.2021**
(21) Anmeldenummer: 18729417.8
(22) Anmeldetag: 06.06.2018
(51) Int. Cl.: H02B 1/052

(54) **TRAGSCHIENENBEFESTIGUNG**
FIXATION TO A SUPPORT RAIL
FIXATION A UN RAIL DE SUPPORT

(30) Priorität: 14.06.2017 DE 102017113063
(43) Veröffentlichungstag der Anmeldung: 22.04.2020
(73) Patentinhaber: Eaton Intelligent Power Limited, Dublin 4 (IE)
(72) Erfinder: KUTSCHE, Wolfgang, 53919 Weilerswist (DE); OTTE, Julia, 51147 Köln (DE); KNÖRRCHEN, Oliver, 50829 Köln (DE)
(74) Vertreter: Eaton IP Group EMEA
(86) Internationale Anmeldenummer: PCT/EP2018/064822
(87) Internationale Veröffentlichungsnummer: WO 2018/228877

(56) Entgegenhaltungen:
- EP-A1- 0 780 939
- DE-U1- 29 506 579
- DE-U1- 29 804 153

## Beschreibung

Die vorliegende Erfindung betrifft eine Tragschienenbefestigung zur lösbaren Befestigung eines Bauteils an einer Tragschiene.

Als Tragschienen bezeichnet man Profilschienen, die vor allem in der Elektrotechnik zur Befestigung von Bauteilen wie Schützen, Motorschutzschaltern, Leistungsschaltern und dergleichen in Verteilerkästen, Schaltschränken und Ähnlichem verwendet werden. Tragschienen sind in der Regel aus Metall, vorzugsweise aus Stahl, Kupfer oder Aluminium, gefertigt. Verschiedene genormte Tragschienentypen sind in der DIN EN 60715 zusammengefasst.

Als Hutschienen (engl. *DIN* Rail) bezeichnet man Tragschienen mit einem im Wesentlichen U-förmigen, hutförmigen Profil. Die Befestigung von elektrischen Bauteilen auf Tragschienen, insbesondere auf Hutschienen, erfolgt in der Regel durch Einhängen eines an dem Gehäuse des zu befestigenden Bauteils ausgebildeten Einhängeelements hinter einer Kante der Tragschiene und anschließendes Einrasten eines beweglichen Befestigungselements hinter einer zweiten Kante der Tragschiene.

Eine entsprechende Befestigungsvorrichtung zur Befestigung eines elektrischen Geräts auf einer Tragschiene ist aus der DE 298 04 153 U1 bekannt. Dort ist eine Vorrichtung beschrieben, umfassend eine Grundplatte, einen unter Federdruck stehenden Schieber als bewegliches Befestigungselement sowie einen Rastvorsprung, wobei der Schieber mit Klemmschrägen zum Festklemmen an die Tragschiene versehen ist und die Tragschienenkante zwischen zwei Seitenschenkeln des Schiebers einklemmbar ist. Der Schieber ist dabei als separates Teil ausgebildet und stützt sich in Einsatzlage über eine zwischenliegende Feder an einem auf der Grundplatte ausgebildeten Führungsblock ab. Die Befestigung des elektrischen Geräts an der Tragschiene erfordert ein unmittelbares Angreifen der montierenden Person an dem Schieber, indem dieser zunächst von Hand gegen die Kraft des Federelements ausgelenkt wird, und sodann durch die Kraft des Federelements zurückschnellt und seine Seitenschenkel dabei klemmend an der Tragschiene zur Anlage kommen. Entsprechend muss der Schieber auch zur Demontage des Geräts von Hand bedient werden und wieder soweit gegen die Kraft der Feder ausgelenkt werden, dass die zuvor eingeklemmte Tragschienenkante wieder freigegeben wird. Da der Schieber auf der der Tragschiene zugewandten Rückseite des elektrischen Bauteils und damit an einer im Schaltschrank im Allgemeinen schwer zugänglichen Position angeordnet ist, ist es ein Nachteil derartiger Vorrichtungen, dass die montierende Person zur Montage und Demontage des elektrischen Bauteils unmittelbar an dem Schieber angreifen muss, insbesondere dann, wenn viele elektrische Bauteile in einem Schaltschrank auf engem Raum montiert sind.

Eine weitere Tragschienenbefestigung ist aus der DE 10 2010 046 620 A1 bekannt, welche einen an einem Gehäuse des zu befestigenden Bauteils ausgeformten Rastvorsprung und einen mit diesem zusammenwirkenden bewegbar gelagerten Schieber offenbart. Der Schieber ist dabei auf einen an dem Gehäuse ausgebildeten Führungssteg aufsetzbar und bezüglich diesem längsverschiebbar, wobei ein zwischenliegendes Federelement durch die Längsverschiebung in eine vorgespannte Position gebracht werden kann. Der Schieber weist weiterhin eine Rastnase auf, welche bei vorgespanntem Federelement in eine Anschlagsaussparung einrasten kann, so dass eine weitere Längsverschiebung des Schiebers verhindert wird. Zur Montage des Bauteils wird bei solchermaßen vormontiertem Schieber der Rastvorsprung an der Tragschiene eingehängt und das Bauteil sodann gegen die Tragschiene gedrückt, wodurch der Schieber an der unteren Kante der Tragschiene abgleitet und dabei entgegen der Kraft des Federelements minimal nach hinten gedrückt wird und sodann hinter der unteren Kante der Tragschiene einrastet. Die an dem Schieber ausgebildete Rastnase verbleibt während dieses Montagevorgangs eingerastet in der Anschlagsaussparung. Zur Demontage des Bauteils ist es erforderlich, den Schieber mittels eines Werkzeugs gegen die Kraftwirkung des Federelements nach hinten zu ziehen. Hierdurch wird eine Eingriffskante des Schiebers von der Kante der Tragschiene entfernt und das Abnehmen des Bauteils von der Tragschiene ermöglicht.

Zwar ermöglicht die in der DE 10 2010 046 620 A1 beschriebene Befestigung eine Montage, bei der nicht unmittelbar an dem Schieber sondern lediglich an dem Bauteil selber angegriffen werden muss, gleichwohl kann die Demontage des Bauteils nur durch ein Angreifen unmittelbar an dem Schieber erfolgen. Zudem ist hierzu der Einsatz eines Werkzeugs erforderlich. Schließlich bietet die beschriebene Befestigung keinen festen Sitz des Bauteils auf der Tragschiene, da der Schieber mit seiner Eingriffskante die Tragschienenkante lediglich hintergreift, ohne hier jedoch klemmend zur Anlage zu kommen. Das Bauteil kann somit zwar nicht ohne Weiteres nach vorne von der Tragschiene abgenommen werden, eine Verschiebung entlang der Tragschiene ist aber aufgrund der unzureichenden Klemmwirkung weiterhin möglich.

Aus dem Dokument EP0780939 A1 ist eine weitere Tragschienenbefestigung bekannt, die die Merkmale des Oberbegriffs des Anspruchs 1 aufweist.

Für viele Anwendungen ist es jedoch erforderlich, dass die montierten Bauteile auch bei hohen seitlichen Verschiebekräften, die beispielsweise durch Schock-, Rüttel- und Schwingbelastungen hervorgerufen werden, rutschfrei befestigt sind. Aus dem Stand der Technik ist es in diesem Fall bekannt, sogenannte Endkappen rechts und links von dem zu befestigenden Bauteil auf der Tragschiene zu fixieren, um ein Verschieben oder Verrutschen des Bauteils auf der Tragschiene zu verhindern. Eine solche Lösung ist jedoch sowohl hinsichtlich des Montageaufwands als auch hinsichtlich einer optimierten Ausnutzung des im Schaltschrank vorhandenen Raums unvorteilhaft.

Die genannten Tragschienenbefestigungen sind so ausgebildet, dass das zu befestigende Bauteil zunächst durch Einhängen eines Einhängeelements hinter einer Kante der Tragschiene lose an dieser gehalten wird. In dieser Lage ist das Bauteil hinsichtlich seiner endgültigen Montageposition ausrichtbar, bevor es durch anschließendes Einrasten des beweglichen Befestigungselements hinter der zweiten Kante der Tragschiene in der gewählten Position festgelegt wird. Eine solche Möglichkeit des Ausrichtens und Verschiebens vor der endgültigen Fixierung ist für bestimmte Anwendungen unerlässlich, beispielsweise dann, wenn das Bauteil über entsprechende Kopplungselemente an Bedienelemente in der benutzerseitigen Schaltschranktür gekoppelt werden soll.

Die Aufgabe der vorliegenden Erfindung liegt daher darin, eine Tragschienenbefestigung zur werkzeuglosen und komfortablen Montage und Demontage eines zu befestigenden Bauteils bereitzustellen, durch welche sowohl eine Ausrichtung des zu befestigenden Bauteils auf der Tragschiene als auch ein fester Sitz des auf der Tragschiene montierten Bauteils ermöglicht wird.

Diese Aufgabe wird gelöst durch eine Tragschienenbefestigung mit den Merkmalen des Patentanspruchs 1.

Vorteilhafte Ausgestaltungen und Weiterbildungen der Erfindung sind Gegenstand der abhängigen Ansprüche.

Mit anderen Worten zeichnet sich die Erfindung dadurch aus, dass durch eine Krafteinwirkung auf die Montageplatte in Richtung auf die Tragschiene eine Auslösebewegung des Schiebers provoziert werden kann, durch welche der Eingriff zwischen den Verrastungselementen gelöst wird. Der Schieber schnellt sodann vermittels der Rückstellkraft des ersten Federelements aus der Verrastungsposition entlang der Führung auf die Kante der Tragschiene zu, bis er an dieser im Bereich seiner Klemmnut klemmend zur Anlage kommt, wodurch die Tragschienenbefestigung an der Tragschiene fixiert wird.

Anders als bei bekannten Lösungen wird der Schieber zur Festlegung der Tragschienenbefestigung somit nicht nur minimal gegen die Rückstellkraft des ersten Federelements aus einer Ausgangsposition heraus ausgelenkt, um die Kante der Tragschiene zu hintergreifen und sich dann um die ausgelenkte Strecke wieder in die Ausgangsposition zurückzubewegen, sondern durch die Krafteinwirkung auf die Montageplatte wird die Verrasterung zwischen Führung und Schieber vollständig gelöst, so dass der Schieber aus einer ersten stabilen Position durch die Rückstellkraft des ersten Federelements in eine zweite stabile Position überführbar ist, in welcher er im Bereich seiner Klemmnut klemmend an der Tragschienenkante zur Anlage kommt. Die Klemmwirkung wird dabei dadurch bewirkt, dass sich das erste Federelement auch in der Verriegelungsposition des Schiebers noch in einer teilweise vorgespannten Position befindet. Die noch verbleibende Rückstellkraft des ersten Federelements drückt den Schieber somit im Bereich seiner Klemmnut gegen die Tragschiene. Hierdurch wird die Tragschienenbefestigung an der Tragschiene fixiert, wobei unter Fixierung im Sinne der Erfindung zu verstehen ist, dass die Tragschienenbefestigung in der Verriegelungslage weder ohne Weiteres nach vorne von der Tragschiene abgenommen noch ohne größeren Kraftaufwand entlang der Tragschiene verschoben werden kann. Auf die Montage von Endkappen zur Begrenzung einer lateralen Bewegung kann somit verzichtet werden.

Die erfindungsgemäße Tragschienenbefestigung zeichnet sich weiterhin dadurch aus, dass sie werkzeugfrei und komfortabel montiert werden kann. Hierzu wird zunächst der Schieber in die Verrastungsposition gebracht und die Tragschienenbefestigung wird mit Hilfe des Einhängeelements auf die Tragschiene aufgesetzt. Die Tragschienenbefestigung hängt nun vermittels ihres Eigengewichts an der Tragschiene. In dieser Ausgangslage wird die Tragschienenbefestigung bereits lose an der Tragschiene gehalten, sie ist aber gleichwohl noch entlang der Tragschiene beweglich und damit hinsichtlich ihrer endgültigen Montageposition ausrichtbar. Zur endgültigen Fixierung ist lediglich eine Krafteinwirkung auf die Montageplatte in Richtung auf die Tragschiene erforderlich. Eine montierende Person muss somit lediglich die Montageplatte gegen die Tragschiene drücken. Durch diese Krafteinwirkung wird erfindungsgemäß eine Auslösebewegung des Schiebers provoziert, durch welche die Verrasterung zwischen Schieber und Führung gelöst wird und der Schieber in oben beschriebener Weise in eine zweite stabile Position überführbar ist. Es ist somit weder erforderlich, unmittelbar an dem Schieber selbst anzugreifen, noch ist der Einsatz von speziellem Werkzeug erforderlich.

Die Montageplatte kann unterschiedlich ausgebildet sein. So kann die Montageplatte als ein separates Bauteil ausgeführt sein oder integraler Bestandteil des zu befestigenden Bauteils sein. Gemäß einer Ausgestaltung der Erfindung kann die Montageplatte eine Wand eines Gehäuses zur Aufnahme des zu befestigenden Bauteils bilden. Eine Krafteinwirkung auf die Montageplatte wird in diesem Fall durch eine Krafteinwirkung auf das gesamte Gehäuse in einer Richtung auf die Tragschiene zu bewirkt. Alternativ kann die Montageplatte auch nach Art einer Adapterplatte ausgebildet sein, auf welcher ein zu befestigendes Bauteil zuvor mit oder ohne Gehäuse montiert wird. In diesem Fall wird die Krafteinwirkung auf die Montageplatte durch eine Krafteinwirkung auf das zu befestigende Bauteil in einer Richtung auf die Tragschiene zu bewirkt.

Gemäß der Erfindung ist die Auslösebewegung eine Kippbewegung des Schiebers, wobei die zweite Kante des Schiebers in der Ausgangslage derart an der Tragschiene zur Anlage kommt, dass sich die Krafteinwirkung auf die Montageplatte in Richtung auf die Tragschiene über die zweite Kante so auf den Schieber überträgt, dass dieser eine Kippbewegung vollzieht. Der Schieber ist dabei vorzugsweise so ausgebildet, dass die zweite Kante des Schiebers über die erste Kante hinausragt, was nachfolgend noch erläutert werden wird. Als Folge einer derartigen Kippbewegung, die auch als Drehbewegung mit einem kleinen Drehwinkel um eine parallel zur Längserstreckung der Tragschiene verlaufende Drehachse aufgefasst werden kann, wird der Eingriff zwischen den Verrastungselementen gelöst und der Schieber geht vermittels der Rückstellkraft des ersten Federelements aus der Verrastungsposition in die Verriegelungsposition über.

Das erste Federelement kann gemäß einer Ausführung der Erfindung einteilig mit dem Schieber ausgebildet sein, beispielsweise direkt an diesen angeformt sein. Das erste Federelement kann dabei als ein beliebiges Federelement ausgebildet sein, welches durch Verschieben des Schiebers auf der Führung ein eine vorgespannte Position gebracht werden kann.

Bei einer alternativen Ausführung der Erfindung können das erste Federelement und der Schieber auch als zwei separate Teile ausgebildet sein. In diesem Fall umfasst die Führung vorzugsweise eine Aufnahme, in der das erste Federelement angeordnet werden kann. Sowohl bei einteiliger als auch bei zweiteiliger Ausbildung von Schieber und erstem Federelement kann das erste Federelement beispielsweise als Schraubenfeder ausgebildet sein.

Über die konkrete Auswahl des ersten Federelements, insbesondere seiner Abmessungen und seiner Federkonstante, kann eine Feinabstimmung des Befestigungsmechanismus vorgenommen werden. Über die Auswahl des ersten Federelements kann die Kraftwirkung gesteuert werden, vermittels derer der Schieber aus der Verrastungsposition in die Verriegelungsposition übergeht, und auch die Stärke der Klemmwirkung des Schiebers an der Tragschiene in der Verriegelungsposition kann über die Auswahl des ersten Federelements eingestellt werden.

Es kann vorgesehen sein, dass an der Montageplatte ein Anschlag ausgebildet ist, welcher die Bewegung des Schiebers beim Übergang aus der Verrastungsposition in die Verriegelungsposition begrenzt. Ein solcher Anschlag ist dabei vorzugsweise derart angeordnet, dass er den Schieber nicht daran hindert, mit seiner Klemmnut klemmend an der Tragschiene zur Anlage zu kommen.

Bei einem Ausführungsbeispiel der Erfindung sind die Verrastungselemente an der Führung als Rastnasen und die Verrastungselemente am dem Schieber als korrespondierende Ausnehmungen ausgebildet, in welche die Rastnasen in der Verrastungsposition einrasten.

Bei einer alternativen Ausgestaltung der Erfindung sind die Verrastungselemente an der Führung als Langlöcher und die Verrastungselemente an dem Schieber als Rasthaken ausgebildet, welche in der Verrastungsposition in die Langlöcher hineingreifen. Eine solche Ausgestaltung der Verrastungselemente kann fertigungstechnische Vorteile aufweisen. Grundsätzlich sind über die genannten Ausführungen hinaus auch beliebige andere Ausgestaltungen der Verrastungselemente denkbar, solange in der Verrastungsposition eine Verrastung zwischen Führung und Schieber gegeben ist, welche durch die Auslösebewegung des Schiebers gelöst werden kann.

Gemäß einem Vorschlag der Erfindung umfasst der Schieber mindestens ein zweites Federelement, wobei die Auslösebewegung des Schiebers durch eine Krafteinwirkung auf die Montageplatte in Richtung auf die Tragschiene und gegen die Kraft des mindestens einen zweiten Federelements provoziert werden kann. Durch den Einsatz von mindestens einem zweiten Federelement und durch die konkrete Auswahl dieses Federelements, insbesondere durch dessen Federkonstante, kann der für die Auslösebewegung erforderliche Krafteinsatz gesteuert werden. Auf diese Weise ist es möglich, durch die Wahl des mindestens einen zweiten Federelement einen bestimmten Schwellenwert für die Kraftwirkung festzulegen, so dass der Schieber nicht bereits durch einen leichten Kontakt mit der Tragschiene beim anfänglichen Einhängen der Tragschienenbefestigung versehentlich auslöst. Es muss ein von der Federkraft des mindestens einen zweiten Federelements abhängiger Mindestkrafteinsatz geleistet werden, damit der Schieber auslöst und aus der Verrastungsposition in die Verriegelungsposition übergeht.

Es kann vorgesehen sein, dass der Schieber zwei zweite Federelemente umfasst. Diese können vorzugsweise symmetrisch bezüglich einer Mittelachse des Schiebers angeordnet sein. Die Auslösebewegung des Schiebers wird in diesem Fall durch eine Krafteinwirkung auf die Montageplatte gegen die Kraft der beiden zweiten Federelemente ausgelöst.

Grundsätzlich kann das mindestens eine zweite Federelement dabei einteilig mit dem Schieber ausgebildet sein, wodurch die Herstellung vereinfacht wird und sich eine größere Stabilität des Verbunds aus Schieber und Federelement ergibt. Insbesondere können somit der Schieber, das erste Federelement und das mindestens eine zweite Federelement einteilig ausgebildet werden.

Der Schieber kann vorzugsweise aus einem Federstahl gefertigt sein. Federstahl bietet die für die vorgesehene Anwendung erforderliche Festigkeit bei gleichzeitiger Elastizität des Werkstoffs. Grundsätzlich sind aber auch andere geeignete Materialien denkbar. So kann der Schieber beispielweise auch aus einem geeigneten Kunststoff gefertigt sein. Das erste Federelement, das mindestens eine zweite Federelement und der Schieber können dabei aus dem gleichen oder aus unterschiedlichen Materialien gefertigt sein, insbesondere können also auch das erste Federelement und/oder das mindestens eine zweite Federelement aus einem Federstahl oder aus einem Kunststoff gefertigt sein.

Eine Ausführung der Erfindung sieht vor, dass das mindestens eine zweite Federelement als Blattfeder ausgebildet ist. Bei einer Ausführung mit zwei zweiten Federelementen können beide zweite Federelemente als baugleiche Blattfedern ausgebildet sein.

Die Führung kann zwei Führungsschienen umfassen, die zwischen sich eine Aufnahme für das erste Federelement ausbilden können. Die beiden Führungsschienen verlaufen vorzugsweise parallel zueinander und umfassen jeweils ein Verrastungselement, welches beispielsweise als Rastnase oder als Langloch ausgebildet sein kann. Der Schieber ist in diesem Fall schlittenartig ausgebildet, so dass er die beiden Führungsschienen in Einsatzlage umgreift und auf diesen verschiebbar ist. An dem Schieber sind Verrastungselemente, beispielsweise Ausnehmungen oder Vorsprünge, ausgebildet, die mit den an den Führungsschienen ausgebildeten Verrastungselementen in oben bereits beschriebener Weise zusammenwirken können, so dass der Schieber bei vorgespanntem ersten Federelement in einer Verrastungsposition einrasten kann.

Um bei separat ausgebildetem ersten Federelement dieses durch eine Verschiebung des Schiebers in eine vorgespannte Position zu bringen, kann an dem Schieber ein Mitnahmeelement ausgebildet sein, welches in Einsatzlage an einem Ende des in der Aufnahme angeordneten ersten Federelements zur Anlage kommt und dieses bei einer Verschiebung des Schiebers entlang der Führung zusammendrückt und so in eine vorgespannte Position überführt. Das Federelement kann sich dabei mit seinem zweiten Ende an einer Begrenzungswand der Aufnahme, in welcher es angeordnet ist, abstützen. Um den Schieber in die Verrastungsposition zu bringen, wird der Schieber soweit entlang der Führung verschoben, bis die an der Führung und an dem Schieber ausgebildeten Verrastungselemente miteinander verrasten, so dass der Schieber bei vorgespanntem ersten Federelement eine erste stabile Position einnimmt. Aus dieser Verrastungsposition heraus kann der Schieber, wie oben bereits beschrieben, ausgelöst und in die zweite stabile Position, die Verriegelungsposition, überführt werden.

Um das mit Hilfe der erfindungsgemäßen Tragschienenbefestigung befestigte Bauteil wieder von der Tragschiene zu lösen, ist es gemäß der Erfindung vorgesehen, dass der Schieber ausgehend von der Verriegelungslage der Tragschienenbefestigung durch eine Bewegung der Montageplatte in einer Richtung, welche ein Abheben des Einhängeelements von der Tragschiene ermöglicht, aus der Verriegelungsposition wieder in die Verrastungsposition und die Tragschienenbefestigung auf diese Weise wieder in die Ausgangslage überführt werden kann. Mit anderen Worten kann ein zu befestigendes Bauteil nicht nur werkzeuglos montiert sondern auch werkzeuglos wieder demontiert werden, indem ein Benutzer die Montageplatte bzw. das Bauteil fasst und in einer Richtung, die ein Abheben des Einhängeelements von der Tragschiene ermöglicht, also im Allgemeinen in einer Richtung vertikal nach oben, bewegt. Durch diese Bewegung kommt es zu einer Relativbewegung zwischen dem nach wie vor mit seiner Klemmnut an der Tragschiene anliegenden Schieber und der mit der Montageplatte verbundenen Führung gegen die Rückstellkraft des ersten Federelements. Letzteres wird wieder stärker zusammengedrückt und zwar bis zu demjenigen Punkt, an dem die Verrastungselemente von Schieber und Führung wieder miteinander verrasten. Sobald die Verrastungselemente wieder miteinander in Eingriff stehen, befindet sich der Schieber wieder in seiner ersten stabilen Position, der Verrastungsposition. Die Tragschienenbefestigung bzw. das mit dieser verbundene Bauteil kann nun einfach von der Tragschiene abgenommen werden oder an eine andere Stelle der Tragschiene verschoben werden, wo es durch eine Kraftwirkung auf die Montageplatte in oben bereits beschriebener Weise wieder festgelegt werden kann.

Die erfindungsgemäße Tragschienenbefestigung zeichnet sich somit dadurch aus, dass eine Montage und eine Demontage eines Bauteils werkzeuglos erfolgen kann und eine montierende Person nicht umständlich an dem rückseitig liegenden Schieber angreifen muss, um die Arretierung bzw. Lösung des Bauteils zu bewirken. Vielmehr kann das Bauteil für beide Vorgänge bequem von vorne gefasst werden, so dass Montage und Demontage auch unter beengten Platzverhältnissen komfortabel durchgeführt werden können. Schließlich zeichnet sich die erfindungsgemäße Tragschienenbefestigung darüber hinaus dadurch aus, dass sie aufgrund der zwei stabilen Positionen, die der Schieber einnehmen kann, sowohl eine gute Ausrichtbarkeit des zu befestigenden Bauteils in der Verrastungsposition des Schiebers als auch eine besonders gute Fixierung auf der Tragschiene in der Verriegelungsposition erreicht.

Gemäß einer weiteren Ausgestaltung der Erfindung umfasst der Schieber eine Öffnung für die Einführung eines Werkzeugs. Wenngleich es erfindungsgemäß besonders vorteilhaft ist, dass die Tragschienenbefestigung in oben beschriebener Weise werkzeuglos von der Tragschiene gelöst werden kann, kann der Schieber alternativ oder zusätzlich auch durch Einführen eines Werkzeugs, beispielsweise eines Schraubendrehers, in die dafür vorgesehene Öffnung aus der Verriegelungsposition zurück in die Verrastungsposition bewegt werden.

Im Folgenden wird die Erfindung anhand von Ausführungsbeispielen und unter Bezugnahme auf die beigefügten Zeichnungen näher erläutert. Es zeigen:
- Figur 1:: in schematischer Seitenansicht ein mittels einer erfindungsgemäßen Tragschienenbefestigung an einer Tragschiene befestigtes Bauteil;
- Figur 2:: in perspektivischer Ansicht eine als Wand eines Gehäuses ausgebildete Montageplatte einer erfindungsgemäßen Tragschienenbefestigung;
- Figur 3:: ein Ausschnitt aus Figur 2 in vergrößerter Darstellung;
- Figur 4:: ein erstes Ausführungsbeispiel eines Schiebers einer erfindungsgemäßen Tragschienenbefestigung in perspektivischer Ansicht von oben;
- Figur 5:: der Schieber aus Figur 4 in perspektivischer Ansicht von unten;
- Figur 6:: die erfindungsgemäße Tragschienenbefestigung mit dem Schieber in der Verrastungsposition in einer Schnittansicht;
- Figur 7:: die erfindungsgemäße Tragschienenbefestigung mit dem Schieber in der Verriegelungsposition in einer Schnittansicht;
- Figur 8:: eine weitere Schnittansicht des in Figur 7 gezeigten Zustands , in welcher das erste Federelement sichtbar ist;
- Figur 9:: der in Figur 7 gezeigte Zustand in perspektivischer Ansicht von schräg oben;
- Figur 10:: ein zweites Ausführungsbeispiel eines Schiebers einer erfindungsgemäßen Tragschienenbefestigung in perspektivischer Ansicht von unten;
- Figur 11:: der Schieber aus Figur 10 in der Verrastungsposition in einer Schnittansicht.

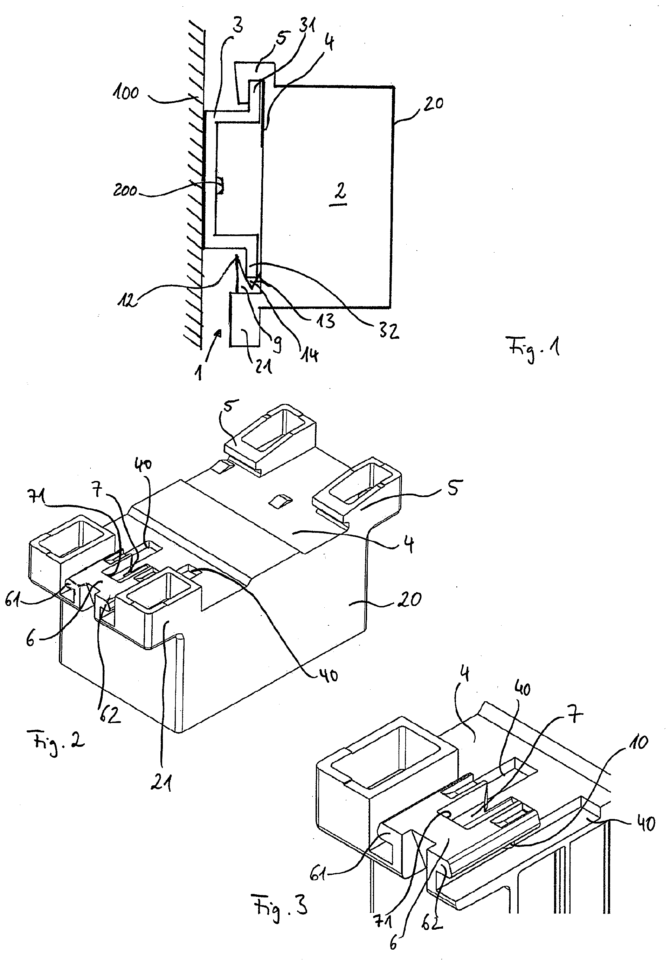

In Figur 1 ist in schematischer Seitenansicht ein mittels einer Tragschienenbefestigung 1 an einer Tragschiene 3 befestigtes Bauteil 2 dargestellt. Die Tragschiene 3 ist als Hutschiene ausgebildet und ist mit Hilfe von Befestigungsmitteln 200 an einer Wand 100, beispielsweise an einer Wand 100 eines Schaltschrankes, befestigt. Das Bauteil 2, beispielsweise ein Schützschalter, ist in einem Gehäuse 20 angeordnet.

Eine Montageplatte 4 bildet eine Wand des Gehäuses 20, und zwar die der Tragschiene 3 zugewandte Wand. Die Montageplatte 4 weist zwei hakenförmig ausgebildete Einhängeelemente 5 auf, von denen in der Darstellung der Figur 1 nur ein Einhängeelement 5 sichtbar ist. Mittels der Einhängeelemente 5 kann das Bauteil 2 in dem Gehäuse 20 auf die Tragschiene 3 aufgesetzt bzw. an diese angehangen werden. Die Einhängeelemente 5 umgreifen hierzu die obere freie Kante 31 der Hutschiene, wie in Figur 1 dargestellt. Ein Schieber 9 wirkt mit der Montageplatte 4 zusammen, was im Folgenden noch ausführlicher erläutert werden wird. Mit Hilfe des Schiebers 9 kann das Gehäuse 20 des Bauteils 2 an der Hutschiene fixiert werden. Der Schieber 9 umfasst hierzu eine erste Kante 12 sowie eine von dieser beabstandete zweite Kante 13 und eine zwischen der ersten Kante 12 und der zweiten Kante 13 ausgebildete Klemmnut 14. In einer in Figur 1 gezeigten Verriegelungsposition des Schiebers 9 kommt dieser im Bereich seiner Klemmnut 14 klemmend an der unteren freien Kante 32 der Tragschiene 3 zur Anlage, wodurch die Tragschienenbefestigung 1 an der Tragschiene 3 fixiert wird.

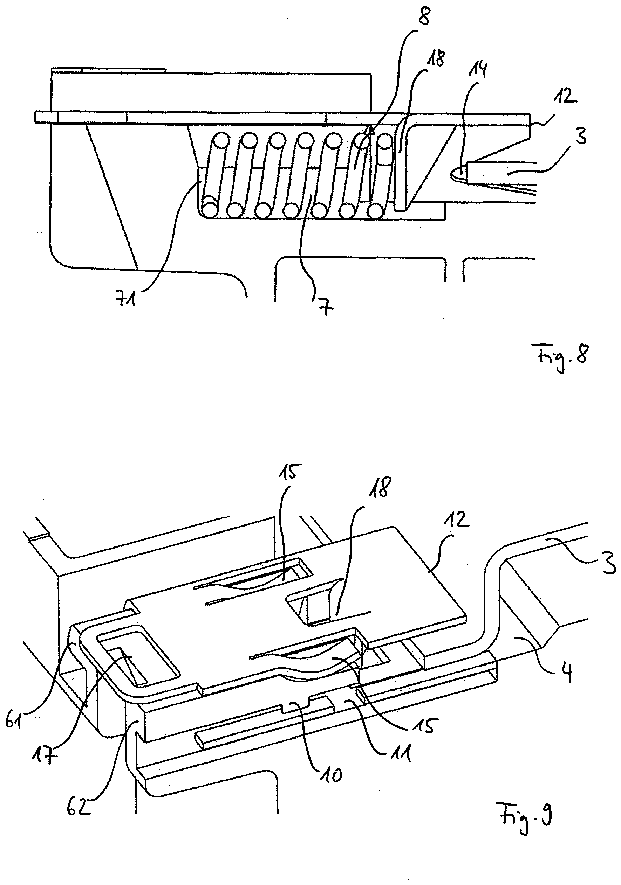

Der Schieber 9 wirkt mit einer an der Montageplatte 4 ausgebildeten Führung 6 zusammen, welche in der Darstellung der Figur 1 hinter dem Gehäuseabschnitt 21 liegt und daher in dieser Darstellung nicht zu sehen. Die Führung 6 ist aber aus der Figur 2 ersichtlich, in welcher das Gehäuse 20 mit nach oben gerichteter Montageplatte 4 dargestellt ist. Die Führung 6 umfasst zwei Führungsschienen 61, 62, die zwischen sich eine Aufnahme 7 für ein erstes Federelement 8 ausbilden. Das erste Federelement 8, welches als Schraubenfeder ausgebildet ist, ist in Figur 2 der Übersichtlichkeit wegen nicht dargestellt. Die Anordnung des Federelements 8 in der Aufnahme 7 ist aber aus der Darstellung der Figur 8 ersichtlich. Das Federelement 8 wird lose in die Aufnahme 7 eingelegt und kann sich an einer Begrenzungswand 71 der Aufnahme 7 abstützen.

Figur 3 zeigt einen Ausschnitt aus Figur 2 in vergrößerter Darstellung, bei der darüber hinaus der Gehäuseabschnitt 21 entfernt wurde, um den Blick auf die Führung 6 freizugeben. In dieser Darstellung ist ein an der Unterseite der Führungsschiene 62 als vorstehende Rastnase 10 ausgebildetes Verrastungselement zu erkennen. Eine ebensolche Rastnase 10 ist an gleicher Stelle an der Führungsschiene 61 ausgebildet, was in der Darstellung der Figur 3 jedoch nicht zu erkennen ist. Die Funktion dieser Rastnasen wird im Folgenden im Zusammenhang mit dem Schieber 9 noch genauer erläutert.

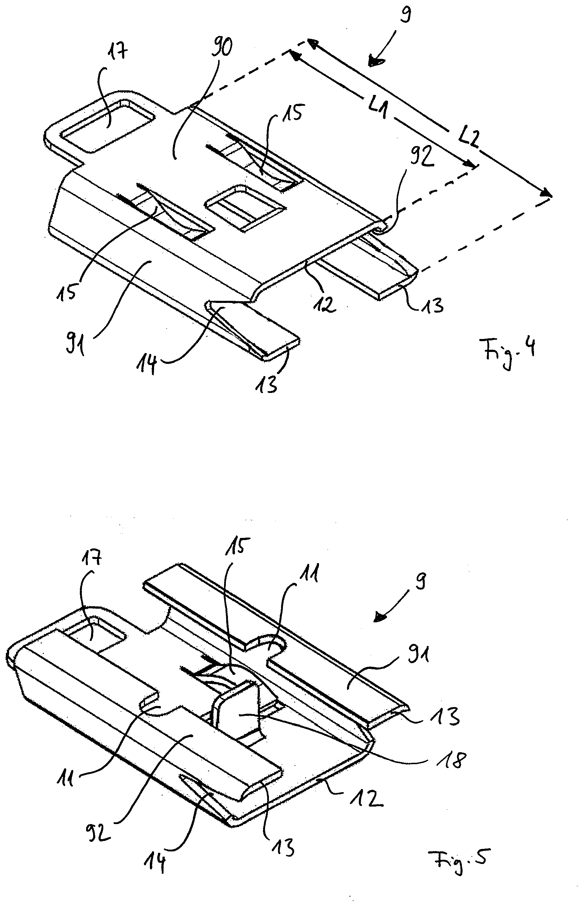

Der Schieber 9 ist in einer Ansicht von oben bzw. von unten in den Figuren 4 und 5 dargestellt. Der Schieber 9 ist schlittenförmig ausgebildet und weist einen Basisschenkel 90 und zwei an diesen angeformte Seitenschenkel 91, 92 auf. Im Querschnitt ist der Schieber 9 im Wesentlichen trapezförmig, das heißt, die Seitenschenkel 91, 92 schließen mit dem Basisschenkel 90 jeweils einen Winkel von etwas mehr als 90° ein. Der Basisschenkel 90 weist eine erste Kante 12 auf, während die Seitenschenkel 91, 92 eine zweite Kante 13 aufweisen. Dabei ragen die Seitenschenkel 91, 92 mit der zweiten Kante 13 über die erste Kante 12 des Basisschenkels 90 hinaus, so dass die in Figur 4 eingezeichnete Länge L2 größer ist als die Länge L1. Zwischen der ersten Kante 12 und der zweiten Kante 13 ist eine Klemmnut 14 ausgebildet. Im Bereich des Basisschenkels 90 sind zwei als Blattfedern ausgebildete zweite Federelemente 15 in den Schieber 9 eingelassen. An seinem den Kanten 12 und 13 abgewandten Ende umfasst der Schieber 9 eine Öffnung 17 für die Einführung eines Werkzeugs.

Aus Figur 5 sind zwei auf der Unterseite der Seitenschenkel 91, 92 ausgebildete Ausnehmungen 11 ersichtlich, welche geeignet sind, mit den an den Führungsschienen 61, 62 ausgebildeten Rastnasen 10 zusammenzuwirken. Insbesondere können die Rastnasen 10 derart mit den Ausnehmung 11 in Eingriff gebracht werden, dass der Schieber 9 auf der Führung 6 in einer Verrastungsposition einrastet, was nachfolgend genauer erläutert wird.

Zur Montage der Tragschienenbefestigung wird zunächst das erste Federelement 8 in die Aufnahme 7 zwischen den Führungsschienen 61, 62 eingelegt. Der Schieber 9 wird sodann auf die Führung 6 aufgeschoben, und zwar in einer Ausrichtung, die aus der Darstellung der Figur 9 zu erkennen ist. Ein an dem Schieber 9 ausgebildetes Mitnahmeelement 18, welches aus der Figur 5 ersichtlich ist, kommt bei auf die Führung 6 aufgeschobenem Schieber 9 an einem Ende des in der Aufnahme 7 angeordneten ersten Federelements 8 zur Anlage. An seinem anderen Ende stützt sich das erste Federelement 8 an der Begrenzungswand 71 der Aufnahme 7 ab. Durch eine Verschiebung des Schiebers 9 entlang der Führung 6 wird das erste Federelement 8 zusammengedrückt und in eine vorgespannte Position überführt. Die Verschiebung des Schiebers 9 erfolgt dabei soweit, bis die an den Führungsschienen 61, 62 ausgebildeten Rastnasen 10 in die an dem Schieber 9 ausgebildeten Ausnehmungen 11 eingreifen und der Schieber 9 in einer Verrastungsposition einrastet.

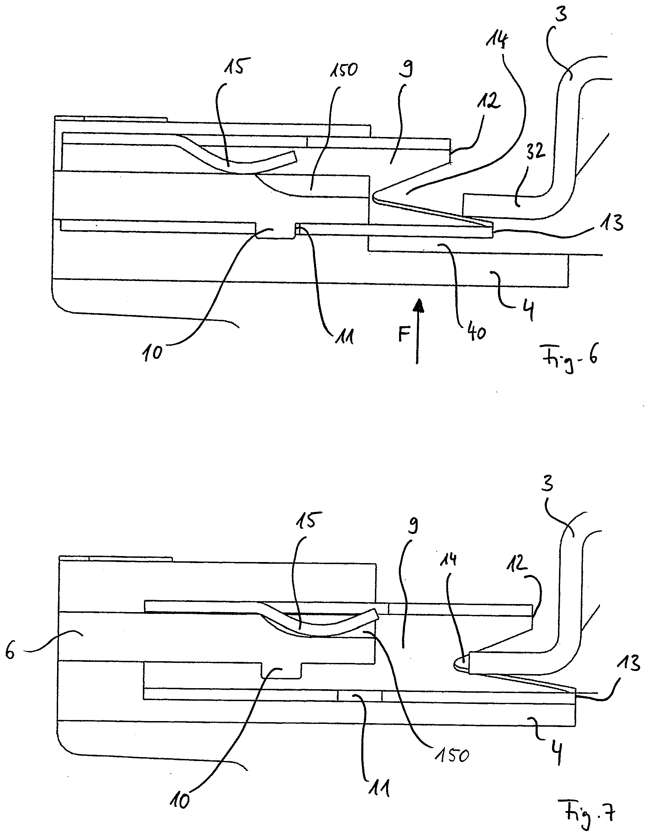

Mit dem Schieber 9 in der Verrastungsposition kann das Gehäuse 20 nun vermittels der Einhängeelemente 5 an die Tragschiene 3 angehangen werden. In dieser Ausgangslage ist das Gehäuse 20 entlang der Tragschiene verschiebbar und ausrichtbar. Dieser Zustand ist in Figur 6 dargestellt. Hier wird insbesondere deutlich, dass die Kante 12 in der Ausgangslage aufgrund der kürzeren Länge L1 bereits hinter der unteren freien Kante 32 der Tragschiene zu liegen kommt, während die Kante 13 aufgrund der längeren Länge L2 auf der dem Benutzer zugewandten Seite der unteren freien Kante 32 an dieser anliegt.

Sobald die gewünschte Montageposition festgelegt ist, kann durch eine Krafteinwirkung auf die Montageplatte 4 in Richtung auf die Tragschiene 3 gemäß dem Pfeil F in Figur 6 und gegen die Kraft der zweiten Federelemente 15 eine Auslösebewegung des Schiebers 9 provoziert werden, durch welche der Eingriff zwischen den Rastnasen 10 und den Ausnehmungen 11 gelöst wird und der Schieber 9 vermittels der Rückstellkraft des ersten Federelements 8 aus der Verrastungsposition in eine Verriegelungsposition überführt wird. In dieser Verriegelungsposition kommt der Schieber 9 im Bereich der Klemmnut 14 klemmend an der Tragschiene 3 zur Anlage und die Tragschienenbefestigung 1 ist in einer Verriegelungslage an der Tragschiene 3 fixiert. Diese Verriegelungslage der Tragschienenbefestigung 1 ist in den Figuren 7 bis 9 dargestellt. Man erkennt, dass die Rastnasen 10 nicht mehr mit den Ausnehmungen 11 in Eingriff stehen und der Schieber 9 im Bereich seiner Klemmnut 14 klemmend an der unteren freien Kante 32 der Tragschiene 3 anliegt. Das erste Federelement 8, vgl. Figur 8, befindet sich auch in der Verriegelungslage der Tragschienenbefestigung 1 noch in einer vorgespannten Position und die verbleibende Rückstellkraft des ersten Federelements 8 ruft die Klemmwirkung des Schiebers 9 an der Tragschiene 3 hervor. Die zweiten Federelemente 15 kommen in der Verriegelungsposition des Schiebers 9 in in der Führung 6 ausgebildeten Ausnehmungen 150 zu liegen.

Die Auslösebewegung ist eine Kippbewegung des Schiebers 9. Wie oben bereits erläutert, kommt die zweite Kante 13 des Schiebers 9 in der Ausgangslage derart an der unteren freien Kante 32 der Tragschiene 3 zur Anlage, dass sich die Krafteinwirkung auf die Montageplatte 4 in Richtung auf die Tragschiene 3 über die zweite Kante 13 so auf den Schieber 9 überträgt, dass dieser eine kleine Kippbewegung auf die Montageplatte 4 zu vollzieht. Um diese Kippbewegung zu erleichtern, weist die Montageplatte 4 Ausnehmungen 40 auf, vergleiche Figuren 2 und 3, in welche die Seitenschenkel 91, 92 sich bei der Kippbewegung hineinbewegen können. Aufgrund der Kippbewegung des Schiebers 9 lösen sich die Rastnasen 10 aus den Ausnehmungen 11 und der Schieber 9 schnellt vermittels der Rückstellkraft des ersten Federelements 8 auf die untere freie Kante 32 der Tragschiene 3 zu. Hier kommt er im Bereich seiner Klemmnut 14 klemmend zur Anlage und nimmt eine zweite stabile Position, die Verriegelungsposition, ein. Die Klemmwirkung wird dabei durch die noch verbleibende Rückstellkraft des ersten Federelements 8 erreicht, da das erste Federelement 8 so beschaffen ist, dass es auch in der Verriegelungsposition noch eine ausreichende Vorspannung aufweist. Die Figuren sind insoweit vereinfachte, schematische Darstellungen, als die beim Übergang aus der Verrastungsposition in die Verriegelungsposition des Schiebers 9 vollführte Kippbewegung aus ihnen nicht erkennbar ist.

In der Verriegelungsposition des Schiebers 9 ist die Tragschienenbefestigung 1 und damit das Gehäuse 20 so an der Tragschiene 3 fixiert, dass es weder nach vorne von der Tragschiene 3 abgenommen noch ohne größeren Kraftaufwand entlang der Tragschiene 3 verschoben werden kann. Dieser Zustand wird als Verriegelungslage der Tragschienenbefestigung 1 bezeichnet.

Ausgehend von der Verriegelungslage der Tragschienenbefestigung 1 kann der Schieber 9 durch eine Bewegung der Montageplatte 4 bzw. des Gehäuses 20 in einer Richtung, welche ein Abheben des Einhängeelements 5 von der Tragschiene 3 ermöglicht, also in der Darstellung der Figur 1 in einer Richtung vertikal nach oben, aus der Verriegelungsposition wieder in die Verrastungsposition und die Tragschienenbefestigung 1 auf diese Weise wieder in die Ausgangslage überführt werden. Durch diese Bewegung kommt es zu einer Relativbewegung zwischen dem nach wie vor mit seiner Klemmnut 14 an der Tragschiene 3 anliegenden Schieber 9 und der mit der Montageplatte 4 verbundenen Führung 6 gegen die Rückstellkraft des ersten Federelements 8. Letzteres wird wieder stärker zusammengedrückt und zwar bis zu demjenigen Punkt, an dem die an der Führung 6 ausgebildeten Rastnasen 10 wieder in die an dem Schieber 9 ausgebildeten Ausnehmungen 11 einrasten. Sobald die Rastnasen 10 und Ausnehmungen 11 wieder miteinander in Eingriff stehen, befindet sich der Schieber 9 wieder in seiner ersten stabilen Position, der Verrastungsposition. Die Tragschienenbefestigung 1 sowie das mit dieser verbundene Bauteil 2 kann nun einfach von der Tragschiene 3 abgenommen werden. Auf diese Weise kann auch eine Demontage eines befestigten Bauteils 2 von der Tragschiene 3 werkzeuglos und komfortabel von vorne erfolgen, ohne dass ein Benutzer umständlich hinter das Bauteil greifen müsste, um die Verriegelung zu lösen.

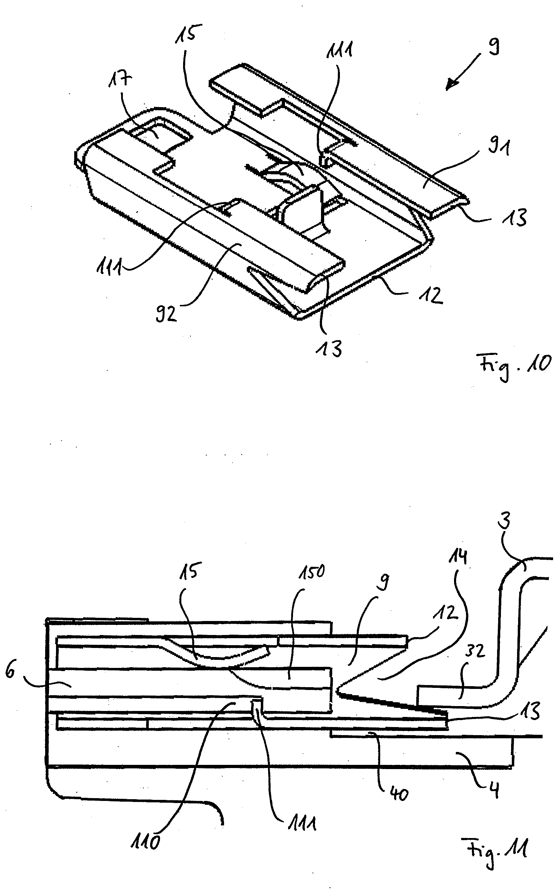

Figur 10 zeigt ein alternatives Ausführungsbeispiel eines Schiebers 9 in perspektivischer Ansicht von unten. Der in der Figur 10 gezeigte Schieber 9 unterscheidet sich von dem in den Figuren 4 und 5 gezeigten Schieber 9 lediglich dadurch, dass die Verrastungselemente nicht als Ausnehmungen sondern als Rasthaken 111 ausgebildet sind. Bei Verwendung eines Schiebers 9 gemäß Figur 10 sind die Verrastungselemente an der Führung 6 so anzupassen, dass die Rasthaken 111 mit den an der Führung 6 ausgebildeten Verrastungselementen in Eingriff gebracht werden können. Vorzugsweise sind die Verrastungselemente an der Führung 6 in diesem Fall als Langlöcher 110 ausgebildet, in welche die Rasthaken 111 in der Verrastungsposition des Schiebers 9 hineingreifen, was in Figur 11 dargestellt ist.

## Patentansprüche

1. Tragschienenbefestigung (1) zur lösbaren Befestigung eines Bauteils (2) an einer Tragschiene (3), umfassend
- eine Montageplatte (4), wobei die Montageplatte (4) mindestens ein Einhängeelement (5) sowie eine Führung (6) aufweist,
- ein erstes Federelement (8), sowie
- einen Schieber (9), wobei der Schieber (9) auf der Führung (6) verschiebbar ist und das erste Federelement (8) durch Verschieben des Schiebers (9) auf der Führung (6) in eine vorgespannte Position gebracht werden kann und wobei an der Führung (6) und an dem Schieber (9) jeweils Verrastungselemente (10, 11, 110, 111) vorgesehen sind, welche bei vorgespanntem ersten Federelement (8) derart miteinander in Eingriff gebracht werden können, dass der Schieber (9) in einer Verrastungsposition einrastet, wobei die Tragschienenbefestigung (1) in einer Ausgangslage, in welcher der Schieber (9) sich in der Verrastungsposition befindet und in welcher die Montageplatte (4) vermittels des Einhängeelements (5) auf die Tragschiene (3) aufgesetzt ist, entlang der Tragschiene (3) beweglich ist, wobei der Schieber (9) eine erste Kante (12) sowie eine von dieser beabstandete zweite Kante (13) und eine zwischen der ersten Kante (12) und der zweiten Kante (13) ausgebildete Klemmnut (14) umfasst, und wobei ausgehend von der Ausgangslage durch eine Krafteinwirkung auf die Montageplatte (4) in Richtung auf die Tragschiene (3) eine Auslösebewegung des Schiebers (9) provoziert werden kann, durch welche der Eingriff zwischen den Verrastungselementen (10, 11) gelöst wird und der Schieber (9) vermittels der Rückstellkraft des ersten Federelements (8) aus der Verrastungsposition in eine Verriegelungsposition überführbar ist, in welcher der Schieber (9) im Bereich der Klemmnut (14) klemmend an der Tragschiene (3) zur Anlage kommt und die Tragschienenbefestigung (1) in einer Verriegelungslage an der Tragschiene (3) fixiert ist, wobei die Auslösebewegung eine Kippbewegung des Schiebers (9) ist, wobei die zweite Kante (13) des Schiebers (9) in der Ausgangslage derart an der Tragschiene (3) zur Anlage kommt, dass sich die Krafteinwirkung auf die Montageplatte (4) in Richtung auf die Tragschiene (3) über die zweite Kante (13) so auf den Schieber (9) überträgt, dass dieser eine Kippbewegung vollzieht, **dadurch gekennzeichnet, dass** der Schieber (9) ausgehend von der Verriegelungslage der Tragschienenbefestigung (1) durch eine Bewegung der Montageplatte (4) in einer Richtung, welche ein Abheben des Einhängeelements (5) von der Tragschiene (3) ermöglicht, aus der Verriegelungsposition wieder in die Verrastungsposition und die Tragschienenbefestigung (1) auf diese Weise wieder in die Ausgangslage überführt werden kann.

2. Tragschienenbefestigung (1) nach Anspruch 1, wobei das erste Federelement (8) einteilig mit dem Schieber (9) ausgebildet ist.

3. Tragschienenbefestigung (1) nach einem der Ansprüche 1 oder 2, wobei die Verrastungselemente (10, 11, 110, 111) an der Führung (6) als Rastnasen (10) und die Verrastungselemente (10, 11, 110, 111) an dem Schieber (9) als korrespondierende Ausnehmungen (11) ausgebildet sind, in welche die Rastnasen (10) in der Verrastungsposition einrasten.

4. Tragschienenbefestigung (1) nach einem der Ansprüche 1 oder 2, wobei die Verrastungselemente (10, 11, 110, 111) an der Führung (6) als Langlöcher (110) und die Verrastungselemente (10, 11, 110, 111) an dem Schieber (9) als Rasthaken (111) ausgebildet sind, welche in der Verrastungsposition in die Langlöcher (110) hineingreifen.

5. Tragschienenbefestigung (1) nach einem der Ansprüche 1 bis 4, wobei der Schieber (9) mindestens ein zweites Federelement (15) umfasst und dass die Auslösebewegung des Schiebers (9) durch eine Krafteinwirkung auf die Montageplatte (4) in Richtung auf die Tragschiene (3) und gegen die Kraft des mindestens einen zweiten Federelements (15) provoziert werden kann.

6. Tragschienenbefestigung (1) nach Anspruch 5, wobei der Schieber (9) zwei zweite Federelemente (15) umfasst.

7. Tragschienenbefestigung (1) nach einem der Ansprüche 5 oder 6, wobei das mindestens eine zweite Federelement (15) einteilig mit dem Schieber (9) ausgebildet ist.

8. Tragschienenbefestigung (1) nach einem der Ansprüche 5 bis 7, wobei das mindestens eine zweite Federelement (15) als Blattfeder ausgebildet ist.

9. Tragschienenbefestigung (1) nach einem der Ansprüche 1 bis 8, wobei das erste Federelement (8) als Schraubenfeder ausgebildet ist.

10. Tragschienenbefestigung (1) nach einem der Ansprüche 1 bis 9, wobei die Führung (6) zwei Führungsschienen (61, 62) umfasst die zwischen sich eine Aufnahme (7) für das erste Federelement (8) ausbilden.

11. Tragschienenbefestigung (1) nach einem der Ansprüche 1 bis 10, wobei der Schieber (9) aus einem Federstahl gefertigt ist

12. Tragschienenbefestigung (1) nach einem der Ansprüche 1 bis 11, wobei der Schieber (9) eine Öffnung (17) für die Einführung eines Werkzeugs umfasst.

13. Tragschienenbefestigung (1) nach einem der Ansprüche 1 bis 12, wobei die Montageplatte (4) eine Wand eines Gehäuses zur Aufnahme des zu befestigenden Bauteils (2) bildet.

## Claims

1. Support rail fastening means (1) for releasably fastening a component (2) to a support rail (3), comprising
- a mounting plate (4), the mounting plate (4) having at least one suspension element (5) and a guide (6),
- a first spring element (8), and
- a slide (9), the slide (9) being displaceable on the guide (6) and the first spring element (8) being able to be brought into a pretensioned position by moving the slide (9) on the guide (6) and latching elements (10, 11, 110, 111) are provided on the guide (6) and on the slide (9), which elements, when the first spring element (8) is pretensioned, can be brought into engagement with one another in such a way that the slide (9) is in a latching position, the support rail fastening means (1) being movable along the support rail (3) in a starting position in which the slide (9) is in the latching position and in which the mounting plate (4) is placed on the support rail (3) by means of the suspension element (5), the slide (9) having a first edge (12) and a second edge (13) spaced apart therefrom and a clamping groove (14) formed between the first edge (12) and the second edge (13), and, starting from the starting position, a force acting on the mounting plate (4) in the direction of the support rail (3) being able to induce a triggering movement of the slide (9) through which the engagement between the latching elements (10, 11) is released and the slide (9) can be transferred by means of the restoring force of the first spring element (8) from the latching position to a locking position in which the slide (9) in the region of the clamping groove (14) comes to rest against the support rail (3) and the support rail fastening means (1) is fixed in a locking position on the support rail (3), the triggering movement being a tilting movement of the slide (9), the second edge (13) of the slide (9) coming to rest on the support rail (3) in the starting position such that the force acting on the mounting plate (4) in the direction of the support rail (3) is transferred via the second edge (13) to the slide (9) such that said slide performs a tilting movement, **characterized in that** the slide (9), starting from the locking position of the support rail fastening means (1) by a movement of the mounting plate (4) in a direction which allows the suspension element (5) to be lifted off the support rail (3), can be transferred out of the locking position back into the latching position and the support rail fastening means (1) can be transferred back to the starting position in this way.

2. Support rail fastening means (1) according to claim 1, wherein the first spring element (8) is formed in one piece with the slide (9).

3. Support rail fastening means (1) according to either claim 1 or claim 2, wherein the latching elements (10, 11, 110, 111) on the guide (6) are designed as latching lugs (10) and the latching elements (10, 11, 110, 111) on the slide (9) are designed as corresponding recesses (11) into which the latching lugs (10) latch in the latching position.

4. Support rail fastening means (1) according to either claim 1 or claim 2, wherein the latching elements (10, 11, 110, 111) on the guide (6) are designed as slots (110) and the latching elements (10, 11, 110, 111) on the slide (9) are designed as latching hooks (111) which engage in the slots (110) in the latching position.

5. Support rail fastening means (1) according to any of claims 1 to 4, wherein the slide (9) comprises at least one second spring element (15) and wherein the triggering movement of the slide (9) can be induced by a force acting on the mounting plate (4) in the direction of the support rail (3) and counter to the force of the at least one second spring element (15).

6. Support rail fastening means (1) according to claim 5, wherein the slide (9) comprises two second spring elements (15).

7. Support rail fastening means (1) according to either claim 5 or claim 6, wherein the at least one second spring element (15) is formed in one piece with the slide (9).

8. Support rail fastening means (1) according to any of claims 5 to 7, wherein the at least one second spring element (15) is designed as a leaf spring.

9. Support rail fastening means (1) according to any of claims 1 to 8, wherein the first spring element (8) is designed as a helical spring.

10. Support rail fastening means (1) according to any of claims 1 to 9, wherein the guide (6) comprises two guide rails (61, 62) which form a receptacle (7) for the first spring element (8) therebetween.

11. Support rail fastening means (1) according to any of claims 1 to 10, wherein the slide (9) is made from a spring steel.

12. Support rail fastening means (1) according to any of claims 1 to 11, wherein the slide (9) comprises an opening (17) for the introduction of a tool.

13. Support rail fastening means (1) according to any of claims 1 to 12, wherein the mounting plate (4) forms a wall of a housing for receiving the component (2) to be fastened.

## Revendications

1. Fixation de rail de support (1) servant à la fixation amovible d'un composant (2) à un rail de support (3), comprenant
- une plaque de montage (4), la plaque de montage (4) présentant au moins un élément d'accrochage (5) ainsi qu'un guide (6),
- un premier élément de ressort (8), ainsi que
- un coulisseau (9), le coulisseau (9) pouvant être déplacé sur le guide (6) et le premier élément de ressort (8) pouvant être mis dans une position de précontrainte par le déplacement du coulisseau (9) sur le guide (6) et des éléments d'encliquetage (10, 11, 110, 111) respectifs étant prévus sur le guide (6) et sur le coulisseau (9), lesquels pouvant, lors de la précontrainte du premier élément de ressort (8), être mis en prise les uns avec les autres, de sorte que le coulisseau (9) s'enclenche dans une position d'encliquetage, la fixation de rail de support (1) pouvant être déplacée le long du rail de support (3) à une position initiale dans laquelle le coulisseau (9) se trouve dans la position d'encliquetage et dans laquelle la plaque de montage (4) est disposée sur le rail de support (3) au moyen de l'élément d'accrochage (5), le coulisseau (9) comprenant un premier bord (12) ainsi qu'un second bord (13) espacé de celui-ci et une rainure de serrage (14) formée entre le premier bord (12) et le second bord (13), et un mouvement de déclenchement du coulisseau (9) pouvant être provoqué par l'action d'une force sur la plaque de montage (4), à partir de la position initiale, en direction du rail de support (3), par lequel la prise entre les éléments d'encliquetage (10, 11) est libérée et le coulisseau (9) pouvant être déplacé, au moyen de la force de rappel du premier élément de ressort (8), de la position d'encliquetage à une position de verrouillage, dans laquelle le coulisseau (9) vient en appui contre le rail de support (3) par serrage dans la zone de la rainure de serrage (14) et la fixation de rail de support (1) est immobilisée au niveau du rail de support (3) dans une position de verrouillage, le mouvement de déclenchement étant un mouvement de basculement du coulisseau (9), le second bord (13) du coulisseau (9) venant en appui contre le rail de support (3) dans la position initiale de sorte que l'action d'une force sur la plaque de montage (4) en direction du rail de montage (3) est transmise, par l'intermédiaire du second bord (13), au coulisseau (9) de sorte qu'il effectue un mouvement de basculement, **caractérisée en ce que** le coulisseau (9), à partir de la position de verrouillage de la fixation de rail de support (1), peut être ramené, par un mouvement de la plaque de montage (4) dans une direction qui permet à l'élément d'accrochage (5) d'être soulevé du rail de support (3), de la position de verrouillage à la position d'encliquetage, et la fixation de rail de support (1) peut ainsi être ramenée à la position initiale.

2. Fixation de rail de support (1) selon la revendication 1, dans laquelle le premier élément de ressort (8) est formé d'une seule pièce avec le coulisseau (9).

3. Fixation de rail de support (1) selon l'une des revendications 1 ou 2, dans laquelle les éléments d'encliquetage (10, 11, 110, 111) sur le guide (6) sont conçus comme des ergots d'encliquetage (10) et les éléments d'encliquetage (10, 11, 110, 111) sur le coulisseau (9) sont conçus comme des évidements correspondants (11) dans lesquels les ergots d'encliquetage (10) s'enclenchent dans la position d'encliquetage.

4. Fixation de rail de support (1) selon l'une des revendications 1 ou 2, dans laquelle les éléments d'encliquetage (10, 11, 110, 111) sur le guide (6) sont conçus comme des trous oblongs (110) et les éléments d'encliquetage (10, 11, 110, 111) sur le coulisseau (9) sont conçus comme des crochets d'encliquetage (111) qui viennent en prise dans les trous oblongs (110) dans la position d'encliquetage.

5. Fixation de rail de support (1) selon l'une des revendications 1 à 4, dans laquelle le coulisseau (9) comprend au moins un second élément de ressort (15) et dans laquelle le mouvement de déclenchement du coulisseau (9) peut être provoqué par l'action d'une force sur la plaque de montage (4) en direction du rail de support (3) et contre la force de l'au moins un second élément de ressort (15).

6. Fixation de rail de support (1) selon la revendication 5, dans laquelle le coulisseau (9) comprend deux seconds éléments de ressort (15).

7. Fixation de rail de support (1) selon l'une des revendications 5 ou 6, dans laquelle l'au moins un second élément de ressort (15) est formé d'une seule pièce avec le coulisseau (9).

8. Fixation de rail de support (1) selon l'une des revendications 5 à 7, dans laquelle l'au moins un second élément de ressort (15) est conçu comme un ressort à lames.

9. Fixation de rail de support (1) selon l'une des revendications 1 à 8, dans laquelle le premier élément de ressort (8) est conçu comme un ressort hélicoïdal.

10. Fixation de rail de support (1) selon l'une des revendications 1 à 9, dans laquelle le guide (6) comprend deux rails de guidage (61, 62) qui forment entre eux un logement (7) pour le premier élément de ressort (8).

11. Fixation de rail de support (1) selon l'une des revendications 1 à 10, dans laquelle le coulisseau (9) est fabriqué à partir d'un acier à ressorts.

12. Fixation de rail de support (1) selon l'une des revendications 1 à 11, dans laquelle le coulisseau (9) comprend une ouverture (17) pour l'introduction d'un outil.

13. Fixation de rail de support (1) selon l'une des revendications 1 à 12, dans laquelle la plaque de montage (4) forme une paroi d'un boîtier permettant la réception du composant (2) à fixer.
